# EUROPÄISCHE PATENTSCHRIFT

(11) **EP 3 271 947 B1**
(45) Veröffentlichungstag und Bekanntmachung des Hinweises auf die Patenterteilung: **08.04.2020**
(21) Anmeldenummer: 16709681.7
(22) Anmeldetag: 12.02.2016
(51) Int. Cl.: H01L 31/0224, H01L 33/38, H01L 31/05

(54) **SOLARZELLE MIT METALLISCHER LADUNGSTRÄGER-ABLEITSTRUKTUR**
SOLAR CELL WITH A METAL CHARGE CARRIER DISCHARGE STRUCTURE
CELLULE SOLAIRE AYANT UNE STRUCTURE MÉTALLIQUE DE DÉVIATION DE PORTEURS DE CHARGE

(30) Priorität: 13.02.2015 AT 501112015
(43) Veröffentlichungstag der Anmeldung: 24.01.2018
(73) Patentinhaber: SolOcean GmbH, 3300 Amstetten (AT)
(72) Erfinder: STUCKOVÁ, Eva, 83101 Bratislava (SK)
(86) Internationale Anmeldenummer: PCT/AT2016/050028
(87) Internationale Veröffentlichungsnummer: WO 2016/127197

(56) Entgegenhaltungen:
- EP-A1- 0 969 517
- CN-A- 102 130 194
- CN-A- 103 077 977
- JP-A- S5 721 872
- US-A- 3 903 428

## Beschreibung

Die Erfindung betrifft eine Solarzelle mit einer neuartigen, an einer zum Empfangen von solarer Strahlung vorgesehenen Oberfläche einer ersten Halbleiter-Schicht angeordneten Ladungsträger-Ableitstruktur, wie dies in Anspruch 1 angegeben ist.

Wie dies allgemein bekannt ist, sind Solarzellen, auch photovoltaische Zelle genannt, zur Umwandlung von Sonnenstrahlung in elektrische Energie vorgesehen, wobei die Funktionsweise aller Solarzellen auf dem photovoltaischen Effekt beruht. Ein wesentlicher Faktor von Solarzellen ist die Umwandlungseffizienz der Sonnenstrahlung in elektrische Energie, wobei die Umwandlungseffizienz von zahlreichen Faktoren bzw. Verlustfaktoren abhängt. Aus dem Stand der Technik sind mittlerweile zahlreiche Varianten von Solarzellen bekannt, welche unterschiedliche Materialien und/oder unterschiedliche Konstruktionsmerkmale umfassen können. Der Aufbau und die Funktionsweise der unterschiedlichen Varianten von Solarzellen, sowie deren Anordnung in elektrischen Stromkreisen zur Gewinnung und/oder Nutzung der erzeugten, elektrischen Energie, wird im Folgenden als dem Durchschnittsfachmann bekannt vorausgesetzt, und daher nicht im Detail erläutert.

Typische Solarzellen umfassen üblicherweise wenigstens zwei miteinander in Kontakt stehende Schichten aus unterschiedlichen Halbleitermaterialien bzw. Halbleitermaterialien mit unterschiedlichen Eigenschaften, wobei sich an einem Übergangsbereich der beiden Schichten, häufig als pn-Übergang bezeichnet, ein elektrisches Feld ausbildet. Aufgrund der Wirkung des elektrischen Feldes können die durch die Solareinstrahlung erzeugten, positiv geladenen ("Löcher") bzw. negativ geladenen (Elektronen) Ladungsträger - je nach Polung des elektrischen Feldes - in Richtung einer jeweils vom Kontaktbereich abgewandten Oberfläche der jeweiligen Schicht geleitet werden. Die vom Kontaktbereich im Inneren der Zelle abgewandte Oberfläche einer der beiden Schichten ist dabei zum Empfangen der Solarstrahlung vorgesehen. Diese Schicht wird im Folgenden als "erste Schicht" bezeichnet, und umfasst ein "erstes Halbleitermaterial".

Die Ableitung der Ladungsträger aus dieser ersten Schicht ist als besondere Herausforderung anzusehen. Halbleitermaterialien sind im Vergleich mit elektrisch leitenden Materialien, beispielweise Metallen wie Silber oder Aluminium, als schlechte elektrische Leiter mit verhältnismäßig hohem, elektrischen Widerstand zu betrachten. Aus diesem Grund werden üblicherweise auf die zum Empfangen der Solarstrahlung vorgesehene Oberfläche der ersten Schicht metallische Ableitstrukturen bzw. Ableitgitter aufgebracht, um für die in Richtung dieser Oberfläche geleiteten Ladungsträger möglichst kurze Distanzen zu einem jeweilig nächstgelegenen Ladungsträgerableitelement bereitzustellen.

Hinsichtlich der Verringerung des elektrischen Widerstandes in der ersten Schicht wäre es hierbei prinzipiell zweckmäßig, einen möglichst großen Bereich der Oberfläche mit einer metallischen Ableitstruktur, welche durch eine Vielzahl an geradlinig ausgebildeten Kontaktstreifen aufgebaut sein kann, zu versehen. Dabei gilt es jedoch zu berücksichtigen, dass Bereiche unterhalb der von der Ableitstruktur abgedeckten Oberflächenbereiche von der Sonnenstrahlung weitestgehend abgeschattet sind. Photonen, welche auf die Ableitstruktur auftreffen, können daher keine Ladungsträgerpaare bzw. Elektronen-Loch-Paare bilden, was die Effizienz der Solarzelle negativ beeinflusst. Üblicherweise werden zusätzlich zu Kontaktstreifen einer Ableitstruktur Sammelschienen an oder über der Ableitstruktur angeordnet, über welche die Solarzelle beispielsweise mit externen Verbraucherkreisen, oder etwa zur Bildung von Solarpanelen mit weiteren Solarzellen verbunden werden kann.

Prinzipiell ist bekannt, dass durch Optimierung der Ausgestaltungsform der Ableitstrukturen wesentliche Vorteile hinsichtlich betrieblicher und wirtschaftlicher Effizienz von Solarzellen erzielbar sein können. Dies insbesondere auch deshalb, da selbst kleine Verbesserungen der Effizienz bzw. des Wirkungsgrads von Solarzellen angesichts der langen Betriebszeit einer Solarzelle sich insgesamt wesentlich auf die wirtschaftliche Effizienz auswirken können. Weiters kann sich die Ausgestaltungsform eines derartigen Ableitgitters auch wesentlich auf die Langzeiteffizienz und Beschädigungsresistenz der Solarzelle auswirken.

Aus der JPS57-21872 und der CN 102130194 A sind beispielsweise hexagonal strukturierte Ableitgitter bzw. Ableitstrukturen bekannt geworden. In beiden Fällen bilden dünne, linear ausgebildete Kontaktstreifen hexagonale Strukturen auf der für die Aufnahme der Solarstrahlung vorgesehenen Oberfläche der Solarzelle aus. Die hexagonalen Strukturen sind dabei zusammenhängend derart angeordnet, dass eine wabenförmige Struktur ausgebildet ist. Weiters sind jeweils Sammelschienen vorgesehen, welche linear verlaufend über bzw. an der AbLeitstruktur bzw. dem Ableitgitter angeordnet sind, bzw. mit der wabenförrnigen Ableitstruktur verbunden sind.

Aus der CN 103 077 977 A sind beispielsweise hexagonal strukturierte Ableitgitter bzw. Ableitstrukturen bekannt. Die hexagonalen Strukturen werden durch dünne, linear ausgebildete Kontaktstreifen auf der für die Aufnahme der Solarstrahlung vorgesehenen Oberfläche der Solarzelle ausgebildet. Die hexagonalen Strukturen sind dabei zusammenhängend derart angeordnet, dass eine wabenförmige Struktur ausgebildet ist.

Die US 3903428 A offenbart eine Solarzelle an dessen Oberfläche eine Ladungsträger-Ableiterstruktur angeordnet ist, welche mehrere metallische Kontaktstreifen aufweist. Die metallischen Kontaktstreifen können in einem Ausführungsbeispiel in einer Spinnennetzartigen Struktur angeordnet sein. Weiters ist vorgesehen, dass die einzelnen metallischen Kontaktstreifen an einem zentral angeordneten Ring miteinander verbunden sind und durch ein zentral angeordnetes Loch an die Rückseite der Solarzelle geführt werden.

Bei Solarzellen mit metallischen Ableitstrukturen an der lichtzugewandten Oberfläche von Solarzellen besteht weiterhin Verbesserungsbedarf hinsichtlich der Optimierung der geometrischen Ausgestaltungsform bzw. Anordnung der Ableitstruktur.

Aufgabe der vorliegenden Erfindung war es daher, eine verbesserte Solarzelle mit einer optimierten Ladungsträger-Ableitstruktur an der zum Empfangen von Solarstrahlung vorgesehenen Oberfläche bereitzustellen.

Diese Aufgabe der Erfindung wird durch Bereitstellen einer Solarzelle gelöst, welche eine erste Schicht aus einem ersten Halbleitermaterial, und wenigstens eine zweite Schicht aus einem zweiten Halbleitermaterial umfasst. Die erste Schicht weist dabei eine Oberfläche auf, welche zum Empfangen von solarer Strahlung vorgesehen ist. Auf dieser Oberfläche ist eine Ladungsträger-Ableitstruktur angeordnet, welche durch eine Mehrzahl an geradlinig ausgebildeten und mit der ersten Schicht kontaktierten, metallischen Kontaktstreifen gebildet ist. Ferner ist eine Mehrzahl an geradlinig und parallel zueinander verlaufenden Sammelschienen vorhanden, wobei jeder Kontaktstreifen jeweils unmittelbar oder mittelbar über einen oder mehrere andere Kontaktstreifen über eine Kontaktstelle mit wenigstens einer der Sammelschienen elektrisch leitungsverbunden ist. Die Sammelschienen können optional mit der ersten Schicht elektrisch leitend verbunden sein.

Wesentlich ist dabei, dass mehrere Kontaktstreifen ein reguläres Hexagon mit sechs gleich langen Umfangsabschnitten bilden, wobei ferner mehrere reguläre Hexagone eine Gruppe von regulären Hexagonen ausbilden, und mehrere solcher Gruppen an regulären Hexagonen an der Oberfläche angeordnet sind. Die Hexagone jeder Gruppe weisen dabei jeweils unterschiedliche Inkreisradien auf, und sind konzentrisch um einen gemeinsamen Mittelpunkt der jeweiligen Gruppe derart angeordnet, dass die Umfangsabschnitte der Hexagone einer jeweiligen Gruppe parallel zueinander ausgerichtet sind. Außerdem ist vorgesehen, dass die Sammelschienen derart angeordnet sind, dass durch den gemeinsamen Mittelpunkt jeder Gruppe eine der Sammelschienen verläuft, sodass jedes Hexagon einer Gruppe an wenigstens zwei Kontaktstellen mit der durch den gemeinsamen Mittelpunkt verlaufenden Sammelschiene elektrisch leitungsverbunden ist.

Durch die angegebenen Merkmale kann eine Solarzelle bereitgestellt werden, welche eine hochsymmetrische Anordnung der Kontaktstreifen der Ableitstruktur um die Sammelschienen aufweist, wobei jeder der Kontaktstreifen mittel- oder unmittelbar über wenigstens zwei Kontaktstellen mit einer Sammelschiene elektrisch leitungsverbunden ist. Durch diese Ausgestaltung der Ableitstruktur kann Betrieb der Solarzelle eine sehr gute Stromdichteverteilung in der Ableitstruktur und den Sammelschienen erreicht werden. In weiterer Folge können ortsaufgelöste Schwankungen der Betriebstemperatur im Bereich der Oberfläche der ersten Schicht wirksam verringert werden, und kann eine möglichst gleichmäßige Temperaturverteilung während des Betriebs der Solarzelle erreicht werden, was sich positiv auf die Betriebseffizienz bzw. den Wirkungsgrad der Solarzelle auswirkt. Insbesondere bei Solareinstrahlung mit hoher Intensität, und damit einhergehenden, hohen Gesamt-Stromdichten, kann der Wirkungsgrad bzw. die Leistung einer Solarzelle im Vergleich zu einer Solarzelle desselben Typs und derselben Größe mit herkömmlichen Ableitstrukturen, deutlich verbessert werden.

Durch die Vermeidung von hohen, lokalen Stromdichten, können außerdem Kontaktstreifen mit einheitlicher und im Vergleich zum Stand der Technik verhältnismäßig geringer Breite an der Oberfläche der ersten Schicht angeordnet sein. Dies wirkt sich aufgrund der geringeren Abschattung einerseits positiv auf den Wirkungsgrad aus bzw. ist dadurch eine höhere Leistungsausbeute ermöglicht. Andererseits ist dadurch eine Materialersparnis an aufzubringendem Metall erzielbar, und können somit die Herstellungskosten der Solarzelle gesenkt werden.

Schließlich sind durch die hochsymmetrische Anordnung der Gruppen von Hexagone bildenden Kontaktstreifen um die Sammelschienen, für jeden Kontaktstreifen wenigstens zwei Kontaktstellen zu einer Sammelschiene bereitgestellt. So sind im Falle einer Unterbrechung eines Kontaktstreifens, etwa durch umweltverursachte Beschädigungen, Rissbildungen oder dergleichen, alternative elektrische Ableitungspfade für die abzuleitenden Ladungsträger geschaffen, und können die Ladungsträger die Sammelschienen auch bei Beschädigungen der Ableitstruktur über diese alternativen Ableitungspfade erreichen. Dadurch kann die Langzeitbetriebssicherheit und die Beschädigungsresistenz der Solarzelle verbessert werden.

Bei einer Weiterbildung kann vorgesehen sein, dass die Gruppen von regulären Hexagonen zumindest an Teilbereichen der Oberfläche, insbesondere an einem Zentralbereich der Oberfläche, ausgebildet sind. Auf diese Weise kann die Anordnung der Gruppen von regulären Hexagonen in der Ableitstruktur optimal an die jeweilige äußere Umfangsgeometrie bzw. Kontur der Solarzelle angepasst werden. Insbesondere können die Gruppen unabhängig von der äußeren Umfangsgeometrie der Solarzelle an der Oberfläche der ersten Schicht angeordnet bzw. mit der ersten Schicht kontaktiert werden, wobei die Umfangsgeometrie bzw. Kontur, welche die Solarzelle begrenzt, grundsätzlich beliebig gewählt werden kann.

In einer weiteren Ausgestaltungsform kann vorgesehen sein, dass die Gruppen von regulären Hexagonen an der Oberfläche derart angeordnet sind, dass die durch den gemeinsamen Mittelpunkt verlaufenden Sammelschienen jeweils zwei gegenüberliegenden Umfangsabschnitte jedes Hexagons der Gruppen als umfangsabschnitthalbierende rechtwinkelig schneiden. Durch diese Anordnung verlaufen die Sammelschienen durch Punkte der Hexagone der Gruppe, welche die geringstmögliche Umfangsausdehnung der Hexagone darstellen. Dadurch kann die Anzahl an Gruppen von regulären Hexagonen, welche entlang einer Sammelschiene angeordnet werden können, an der Oberfläche der ersten Schicht der Solarzelle erhöht werden. Dadurch lassen sich die mittels der in Gruppen angeordneten, regulären Hexagonen erzielbaren Vorteile nochmalig weiter steigern.

Ferner kann es zweckmäßig sein, wenn die konzentrisch um einen gemeinsamen Mittelpunkt angeordneten, regulären Hexagone aller Gruppen bezüglich ihrer jeweiligen Inkreisradien äquidistant voneinander beabstandet sind, und die jeweiligen Inkreisradien der regulären Hexagone derart gewählt sind, dass alle Gruppen jeweils ein Hexagon mit gleichem Inkreisradius aufweisen, und die Anzahl der konzentrisch um einen gemeinsamen Mittelpunkt angeordneten, regulären Hexagone, für alle Gruppen der Solarzelle gleich gewählt ist. Auf diese Weise kann eine hochsymmetrische, metallische Ableitstruktur auf der Oberfläche der ersten Schicht angeordnet werden, was sich wiederum positiv auf die gleichmäßige Verteilung der Stromdichte und Temperatur während des Betriebs der Solarzelle auswirkt. Außerdem können die Gruppen von regulären Hexagonen möglichst platzsparend an der Oberfläche der ersten Schicht angeordnet werden.

Dabei kann vorgesehen sein, dass die Anzahl der konzentrisch um einen gemeinsamen Mittelpunkt angeordneten, regulären Hexagone aus einem Bereich zwischen 4 und 8, und bevorzugt zwischen 5 und 7 ausgewählt ist.

Insbesondere kann es zweckmäßig sein, dass die Anzahl der konzentrisch um einen gemeinsamen Mittelpunkt angeordneten, regulären Hexagone 6 ist. Durch diese zusätzlichen Merkmale sind Mittel zur möglichst optimalen Anpassung der Gruppen von regulären Hexagonen bzw. der Ableitstruktur an die jeweilige äußere Umfangsgeometrie der Solarzelle bereitgestellt. Insbesondere kann die Umfangsausdehnung der Gruppen in Abhängigkeit vom gewählten, äquidistanten Abstand zwischen den konzentrisch um einen jeweiligen gemeinsamen Mittelpunkt angeordneten Hexagonen, definiert werden.

Ferner kann eine Ausgestaltungsform der Solarzelle vorteilhaft sein, bei welcher wenigstens einer der sechs Umfangsabschnitte des regulären Hexagons mit dem größten Inkreisradius einer Gruppe, beabstandet und parallel ausgerichtet zu einem Umfangsabschnitt eines regulären Hexagons mit dem größten Inkreisradius einer benachbarten Gruppe angeordnet ist. Auf diese Weise können Gruppen von regulären Hexagonen dicht gepackt aneinander angrenzend an der Oberfläche der ersten Halbleiterschicht der Solarzelle angeordnet werden. Dadurch kann auch die Zahl der Gruppen von regulären Hexagonen in der Ableitstruktur bzw. an der Oberfläche der ersten Schicht erhöht werden, wodurch eine nochmalige Verbesserung hinsichtlich einer möglichst gleichmäßigen Verteilung der Stromdichte und Temperatur im Betrieb der Solarzelle erzielbar ist.

Es kann auch zweckmäßig sein, dass wenigstens einer der sechs Umfangsabschnitte des regulären Hexagons mit dem größten Inkreisradius einer Gruppe, den Umfangsabschnitt eines regulären Hexagons mit dem größten Inkreisradius einer benachbarten Gruppe bildet. Auch auf diese Weise können Gruppen von regulären Hexagonen dicht gepackt aneinander angrenzend an der Oberfläche der ersten Halbleiterschicht der Solarzelle angeordnet werden. Zusätzlich können dadurch für die abzuleitenden Ladungsträger zusätzliche Leitungspfade zu Sammelschienen bereitgestellt werden, wodurch im Besonderen die Auswirkung von Beschädigungen der Ableitstruktur an der Oberfläche der ersten Schicht weiter verringert werden kann.

In einer weiteren Ausgestaltungsform der Solarzelle kann vorgesehen sein, dass die Ableitstruktur in Teilbereichen der Oberfläche, insbesondere in Randbereichen der Oberfläche, weitere geradlinig ausgebildete Kontaktstreifen aufweist, welche entweder senkrecht zu den Sammelschienen verlaufend, oder in einem Winkel von 30° bezüglich der Sammelschienen verlaufend, ausgerichtet sind. Dadurch können auch jene Bereiche, insbesondere Randbereiche der ersten Schicht, welche gegebenenfalls wegen der Ausgestaltung der äußeren Umfangsgeometrie bzw. Kontur der Solarzelle nicht von einer Gruppe von regulären Hexagonen erfasst werden können, durch Kontaktstreifen der Ableitstruktur kontaktiert werden. Die angegebene Ausrichtung dieser Kontaktstreifen ermöglicht außerdem eine optimale und platzeffiziente Anpassung an die Teilbereiche der Ableitstruktur, welche durch Gruppen von regulären Hexagonen gebildet sind.

Es kann aber auch zweckmäßig sein, wenn in einer oder mehreren der Gruppen von regulären Hexagonen weitere, geradlinig ausgebildete und senkrecht auf die Kontaktschienen verlaufende Kontaktstreifen angeordnet sind, welche zwei jeweils nächstliegende Ecken von zwei konzentrisch benachbart in der Gruppe angeordneten Hexagonen verbinden. Auf diese Weise können in der Ableitstruktur, insbesondere in den Gruppen von Hexagonen Leitungspfade bzw. Kontaktstreifen angeordnet werden, welche die regulären Hexagone einer Gruppe von Hexagonen untereinander verbinden. Durch diese weiteren Kontaktstreifen können Ladungsträger, insbesondere aus den Randbereichen der Oberfläche der ersten Schicht, über möglichst kurze Strecken in der Ableitstruktur zu einer Sammelschiene transportiert werden. Dadurch kann der elektrische Widerstand der in der Ableitstruktur gesenkt, und damit die Leistungsausbeute der Solarzelle weiter gesteigert werden.

Außerdem kann vorgesehen sein, dass in jeder Gruppe von konzentrisch um einen gemeinsamen Mittelpunkt angeordneten, regulären Hexagonen, jeweils zwei T-förmig ausgebildete Kontaktstreifen angeordnet sind, wobei einer der T-förmigen Kontaktstreifen ausgehend vom gemeinsamen Mittelpunkt auf einer Seite der Sammelschiene, und der andere T-förmige Kontaktstreifen ausgehend vom gemeinsamen Mittelpunkt auf der anderen Seite der Sammelschiene angeordnet ist, und die Dimensionen der T-förmigen Kontaktstreifen kleiner sind als der Inkreisradius des Hexagons mit dem kleinsten Inkreisradius der jeweiligen Gruppe. Auf diese Weise können an der Oberfläche der ersten Schicht auch die Bereiche in der Nähe des gemeinsamen Mittelpunkts einer jeweiligen Gruppe von regulären Hexagonen, durch einen Kontaktstreifen kontaktiert werden.

Weiters kann es sinnvoll sein, dass eine Breite der geradlinig ausgebildeten Kontaktstreifen (8) ausgewählt ist aus einem Bereich zwischen 70 m und 110 m, und bevorzugt zwischen 75 m und 90 m. Durch die angegebenen Bereiche für die Breite der Kontaktstreifen, können Kontaktstreifen mit sehr gut an die Ableitstruktur der Solarzelle angepasster Breite ausgewählt werden. Insbesondere können Kontaktstreifen bereitgestellt werden, welche einerseits hinsichtlich ausreichender Leitfähigkeit und andererseits geringst möglicher Abschattung der unterhalb der Kontaktstreifen liegenden Bereiche der Solarzelle optimiert sind.

Schließlich kann auch vorgesehen sein, dass zwischen jeweils zwei unmittelbar benachbarten und parallel zueinander verlaufenden Kontaktstreifen der Ableitstruktur ein Normalabstand ausgebildet ist, welcher für alle Paare unmittelbar benachbarter und parallel zueinander ausgerichteter Kontaktstreifen auf der gesamten Oberfläche der ersten Schicht gleich gewählt ist, und welcher Normalabstand ausgewählt ist aus einem Bereich zwischen 2,5 mm und 5 mm, und bevorzugt zwischen 2,8 und 3,5 mm. Hierdurch kann einerseits der Normalabstand zwischen zwei benachbarten, parallel zueinander verlaufenden Kontaktstreifen ausreichend groß gewählt werden, um einen möglichst großen, nicht durch die Ableitstruktur abgeschatteten Bereich der Oberfläche der ersten Schicht zu erhalten. Andererseits kann auch ermöglicht werden, dass für die abzuleitenden Ladungsträger möglichst kurze Distanzen zu einem jeweilig nächstgelegenen Kontaktstreifen bereitgestellt sind.

Zum besseren Verständnis der Erfindung wird diese anhand der nachfolgenden Figuren näher erläutert.

Es zeigen jeweils in stark vereinfachter, schematischer Darstellung:
- Fig. 1: einen Aufbau einer üblichen Solarzelle, in stark vereinfachte, schematischer Darstellung, mit einem Ableitgitter gemäß dem Stand der Technik;
- Fig. 2: eine Draufsicht auf eine Ausgestaltungsvariante einer Solarzelle mit einer erfindungsgemäßen Ableitstruktur an der Oberfläche;
- Fig. 3: eine Draufsicht auf eine weitere Ausgestaltungsvariante einer Solarzelle mit einer erfindungsgemäßen Ableitstruktur an der Oberfläche.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

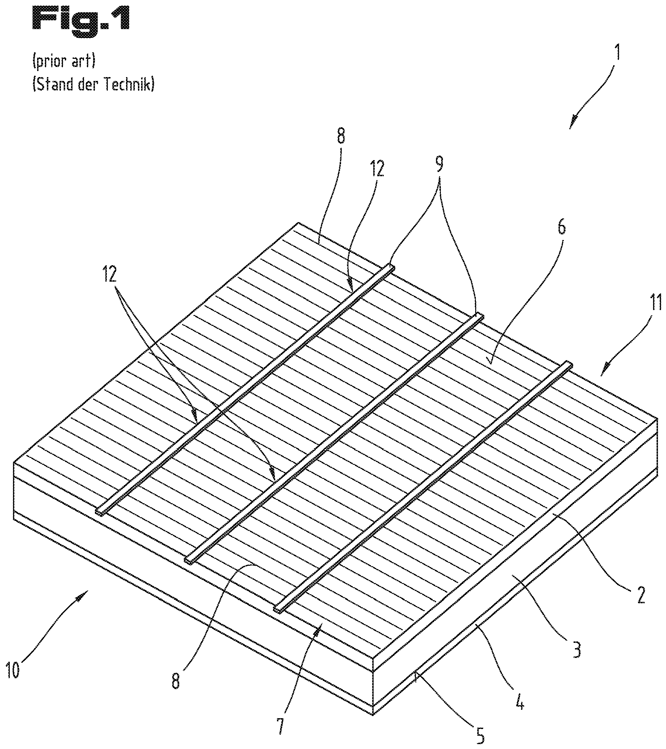

Ein Beispiel für einen zurzeit üblichen Halbleiter-Schichtaufbau einer Solarzelle ist beispielhaft und schematisch und stark vereinfacht in der Fig. 1 dargestellt. Die beispielhaft dargestellte Solarzelle 1 umfasst dabei eine erste Schicht 2 aus einem ersten Halbleitermaterial, und wenigstens eine zweite Schicht 3 aus einem zweiten Halbleitermaterial. Die beiden Halbleitermaterialien der Schichten 2, 3 können dabei zum Beispiel durch unterschiedlich dotierte Siliziumschichten gebildet sein, welche aufgrund der unterschiedlichen Dotierung unterschiedliche Halbleitereigenschaften aufweisen. Alternativ können die erste Schicht 2 und die wenigstens eine, zweite Schicht 3 auch aus verschiedenen Halbleitermaterialien gebildet sein, wie dies beispielsweise bei sogenannten III-V-Halbleiterzellen der Fall ist. Eine gängige Form solcher III-V-Halbleiterzellen sind sogenannte Galliumarsenid-Zellen. Zusätzlich kann der Schichtaufbau einer Solarzelle selbstverständlich noch weitere, bauliche Elemente und/oder Halbleiterschichten umfassen, welche aus Übersichtlichkeitsgründen in der Fig. 1 nicht dargestellt sind. Beispiele für solche weiteren Elemente sind etwa Anti-Reflexionsbeschichtungen, Rückseitenfelder oder weitere, sogenannte Passivierungselemente. Derartige, zusätzliche Elemente oder Schichten können beispielsweise zur Unterdrückung von Rekombinationsvorgängen von durch die Solarstrahlung erzeugten Ladungsträgerpaaren vorgesehen sein.

Die in Fig. 1 beispielhaft und stark vereinfacht, schematisch dargestellte Solarzelle 1 weist weiters eine Ableitelektrode 4 an der Rückseite 5 der zumindest einen, zweiten Schicht 3 auf, welche zum Ableiten der in Richtung der Rückseite 5 der zumindest einen zweiten Schicht 3 fließenden Ladungsträger vorgesehen ist. Wie bereits eingangs dieses Dokuments beschrieben ist, kann es sich dabei je nach Polung des elektrischen Feldes zwischen der ersten Schicht 2 und der zumindest einen zweiten Schicht 3, um positiv geladene oder negativ geladene Ladungsträger handeln. Die Ableitelektrode 4 ist üblicherweise durch ein elektrisch leitendes Metall gebildet, wobei das Metall häufig im Wesentlichen als Schicht flächendeckend auf die Rückseite 5 der zumindest einen zweiten Schicht 3 aufgebracht, bzw. mit der zweiten Schicht 3 kontaktiert ist. Alternativ können auch mehrere Ableitelektroden mit der zweiten Schicht 3 kontaktiert sein, welche beispielsweise durch geradlinig verlaufende Ladungsträger-Sammelschienen in verschiedenen Anordnungen an der Rückseite 5 gebildet sein können.

Die erste Schicht 2 der in der Fig. 1 beispielhaft dargestellten Solarzelle 1 weist eine Oberfläche 6 auf, welche zum Empfangen der solaren Strahlung bzw. des Sonnenlichts vorgesehen ist. Diese Oberfläche 6 umfasst eine Ladungsträger-Ableitstruktur 7, welche in dem in Fig. 1 dargestellten Beispiel zur Veranschaulichung des grundsätzlichen Aufbaus einer Solarzelle 1, gemäß dem Stand der Technik ausgebildet ist. Diese Ableitstruktur 7 ist zum Ableiten der in Richtung der Oberfläche 6 der ersten Schicht 2 fließenden Ladungsträger aus der ersten Schicht 2 vorgesehen.

Die Ableitstruktur 7 im in Fig. 1 dargestellten Beispiel gemäß dem Stand der Technik, ist durch eine Mehrzahl an geradlinig ausgebildeten und mit der ersten Schicht 2 kontaktierten, metallischen Kontaktstreifen 8 gebildet. Weiters ist eine Mehrzahl an geradlinig und parallel zueinander verlaufenden Sammelschienen 9 vorhanden. In dem in Fig. 1 dargestellten Beispiel sind die Sammelschienen 9 geradlinig von einer Seite 10 der Solarzelle 1 zu einer gegenüberliegenden Seite 11 der Solarzelle 1 verlaufend angeordnet. Alle Kontaktstreifen 8 sind senkrecht auf die Sammelschienen 9 verlaufend, und damit jeweils parallel zueinander an der Oberfläche 6, angeordnet. Im in Fig. 1 gezeigten Beispiel gemäß dem Stand der Technik, ist jeder der geradlinig ausgebildeten Kontaktstreifen 8 unmittelbar mit einer oder zwei der Sammelschienen 9 über eine Kontaktstelle 12 elektrisch leitungsverbunden. Aus dem Stand der Technik sind weiters auch Ableitstrukturen bzw. Ableitgitter bekannt, bei welchen geradlinig ausgebildete Kontaktstreifen mittelbar über einen oder mehrere andere bzw. weitere Kontaktstreifen mit Sammelschienen leitungsverbunden sind. Die Sammelschienen 9 können wahlweise ebenfalls mit der ersten Schicht 2 kontaktiert sein, oder nur mit den Kontaktstreifen 8 elektrisch leitungsverbunden sein.

Ableitstruktur 7 und Sammelschienen 9 bilden zusammen eine Ableitelektrode zur Ableitung der in Richtung der Oberfläche 6 der ersten Schicht 2 fließenden Ladungsträger aus. Die Ableitelektrode 4 an der Rückseite 5 der zumindest einen zweiten Schicht 3 und die Sammelschienen 9 an der Oberfläche 6 der ersten Schicht 2 sind üblicherweise zum elektrisch leitenden Verbinden mit Solarzellen-externen Elementen vorgesehen. So können mehrere Solarzellen 1 zum Beispiel zu Solarpanelen bzw. -modulen zusammengeschaltet werden, und über Wechselrichter und gegebenenfalls weitere Strom- bzw. Spannungswandlungselemente mit einem Stromnetz oder direkt mit einem Verbraucherstromkreis verbunden werden. Die genaue Ausgestaltung der elektrisch leitenden Verbindungen der Ableitelektrode 4 und der Sammelschienen 9 mit externen Elementen kann der Fachmann auf dem Gebiet gemäß den jeweiligen Erfordernissen entsprechend vornehmen.

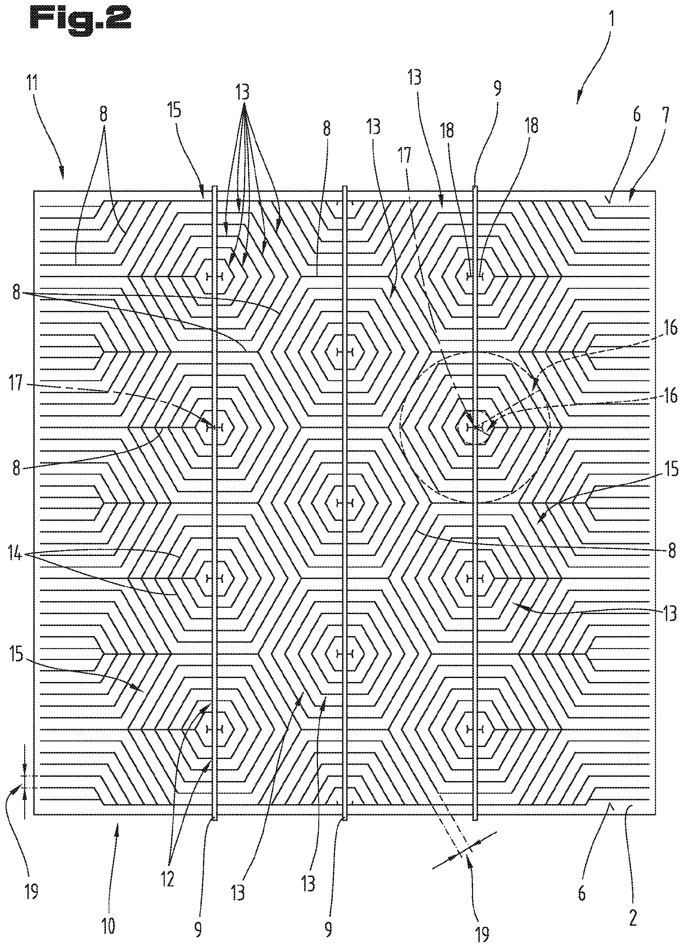

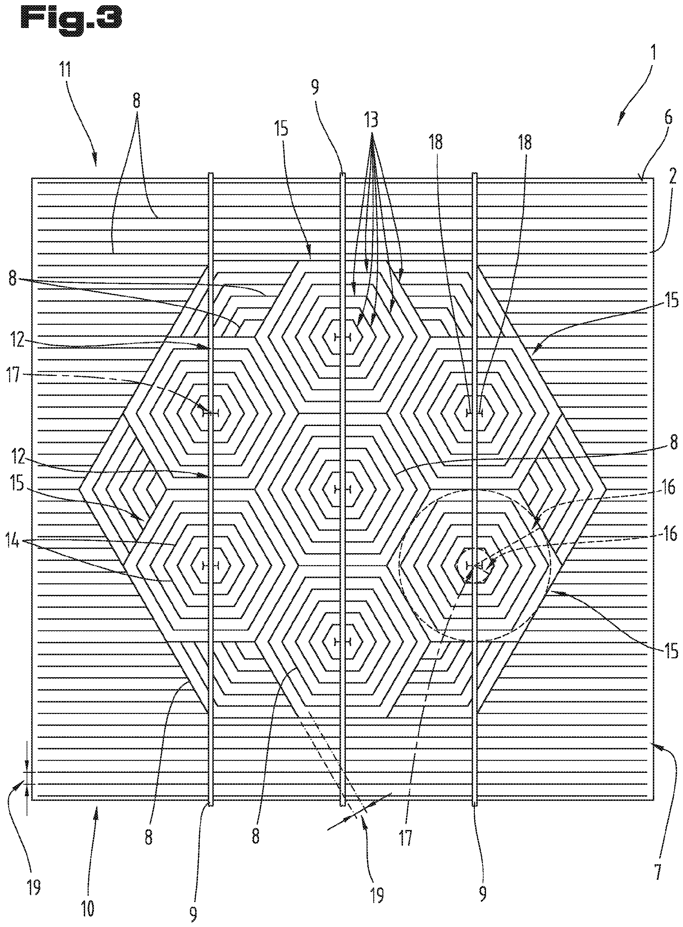

In der Fig. 2 und der Fig. 3 ist jeweils ein Ausführungsbeispiel für die Ausgestaltung der Ableitstruktur 7 einer erfindungsgemäßen Solarzelle 1 dargestellt, wobei die beispielhaft dargestellten Solarzellen 1 zwecks besserer Ersichtlichkeit der jeweiligen Ableitstruktur 7 in Draufsicht auf die Oberfläche 6 der ersten Schicht dargestellt sind. Die in den beiden dargestellten Ausführungsbeispielen gemäß Fig. 2 und Fig. 3 dargestellte Solarzelle 1 weist in der dargestellten Draufsicht von oben einen quadratischen Umriss bzw. eine quadratische Kontur als Umfangsgeometrie auf. Um unnötige Wiederholungen zu vermeiden, werden für gleiche Teile gleiche Bezugszeichen bzw. Bauteilbezeichnungen wie in der vorangegangenen Fig. 1 verwendet, und wird auf die detaillierte Beschreibung in der vorangegangenen Fig. 1 hingewiesen bzw. Bezug genommen.

Wie bereits obenstehend beschrieben, können die in Fig. 2 und Fig. 3 dargestellten Ausführungsbeispiele für erfindungsgemäße Solarzellen 1 durch alle möglichen Schichtaufbauten realisiert sein, bei welchen die Anordnung einer metallischen Ableitstruktur 7 auf einer zum Empfang von solarer Strahlung vorgesehenen Oberfläche 6 notwendig oder zweckmäßig ist. Daher umfasst die Erfindung beispielsweise sowohl mono- als auch polykristalline Siliziumzellen, amorphe Siliziumzellen, III-V-, II-VI- und I-III-VI-Halbleiterzellen, Dünnschichtzellen, sogenannte Konzentratorzellen, sowie weitere aus dem Stand der Technik bekannte Solarzellen, aber auch mögliche künftige Entwicklungen.

Wie aus Fig. 2 und Fig. 3 ersichtlich ist, ist die Ableitstruktur 7 grundsätzlich durch eine Mehrzahl an geradlinig ausgebildete Kontaktstreifen 8 aufgebaut bzw. gebildet, wobei ein geradlinig ausgebildete Kontaktstreifen 8 jeweils mit weiteren gradlinig ausgebildeten Kontaktstreifen 8 verbunden sein kann. Wesentlich für die Verbesserung der Effizienz bzw. des Wirkungsgrades der Solarzelle 1 ist dabei, dass mehrere Kontaktstreifen 8 ein reguläres Hexagon 13 mit sechs gleich langen Umfangsabschnitten 14 bilden. Außerdem bilden jeweils mehrere reguläre Hexagone 13 eine Gruppe 15 von regulären Hexagonen 13, wobei mehrere solcher Gruppen 15 an regulären Hexagonen 13 an der Oberfläche 6 angeordnet sind.

Unter einem regulären Hexagon wird in Übereinstimmung mit der gebräuchlichen Bezeichnung ein Hexagon verstanden, welches sechs gleich lange Umfangsabschnitte bzw. Kanten, sowie die jeweils beiden an den Ecken verbundenen Kanten an allen sechs Ecken jeweils denselben Winkel von 120° zueinander einnehmen. In anderen Worten ausgedrückt, werden die sechs Umfangsabschnitte 14 der Hexagone 13 in der Fig. 2 und der Fig. 3 durch jeweils sechs gleich lange Kontaktstreifen 8 gebildet, wobei zwei jeweils an den Eckpunkten eines Hexagons 13 verbunden Kontaktstreifen 8 zueinander einen Winkel von 120° einnehmen.

Wie aus der Fig. 2 und der Fig. 3 ersichtlich ist, weisen die regulären Hexagone 13 jeder Gruppe 15 von Hexagonen 13 jeweils unterschiedliche Inkreisradien 16 auf, und sind die regulären Hexagone 13 jeder Gruppe 15 konzentrisch um einen gemeinsamen Mittelpunkt 17 der jeweiligen Gruppe 15 angeordnet. Die Anordnung der Hexagone 13 in einer Gruppe 15 ist dabei dergestalt, dass die Umfangsabschnitte 14, 14 der Hexagone 13 parallel zueinander ausgerichtet sind.

Bevorzugt sind dabei die konzentrisch um einen gemeinsamen Mittelpunkt 17 angeordneten, regulären Hexagone 13 aller Gruppen 15 bezüglich ihrer jeweiligen Inkreisradien 16 äquidistant voneinander beabstandet. Außerdem sind die jeweiligen Inkreisradien 16 der regulären Hexagone 13 bevorzugt derart gewählt, dass alle Gruppen 15 jeweils ein Hexagon 13 mit gleichem Inkreisradius 16 aufweisen. Bevorzugt ist weiters, dass die Anzahl der konzentrisch um einen gemeinsamen Mittelpunkt 17 angeordneten, regulären Hexagone 13, für alle an der Oberfläche 6 angeordneten Gruppen 15 gleich gewählt ist, wie dies auch aus den in der Fig. 2 und der Fig. 3 dargestellten, bevorzugten Ausführungsbeispielen ersichtlich ist.

Ferner sind an der Oberfläche 6 der ersten Schicht 2 Sammelschienen 9 angeordnet, wobei die Anordnung der Sammelschienen 9 dergestalt ist, dass durch den gemeinsamen Mittelpunkt 17 jeder Gruppe 15 eine der Sammelschienen 9 verläuft. Auf diese Weise ist jedes Hexagon 13 einer Gruppe 15 bzw. jeder Kontaktstreifen 8, welcher einen Umfangsabschnitt 14 eines Hexagons 13 einer Gruppe 15 bildet, an wenigstens zwei Kontaktstellen 12 mit der jeweiligen durch den gemeinsamen Mittelpunkt 17 verlaufenden Sammelschiene 9 elektrisch leitungsverbunden. Die Anzahl an anzuordnenden Sammelschienen 9 ergibt sich somit aus der jeweiligen Anordnung der Gruppen 15 von regulären Hexagonen 13 an der Oberfläche 6, wobei in den Ausführungsbeispielen gemäß Fig. 2 und Fig. 3 jeweils drei Sammelschienen 9 angeordnet sind.

Dabei können die Gruppen 15 von regulären Hexagonen 13 an der Oberfläche 6 derart angeordnet sein, dass die durch den jeweiligen gemeinsamen Mittelpunkt 17 verlaufenden Sammelschienen 9 jeweils zwei gegenüberliegenden Umfangsabschnitte 14 jedes Hexagons 13 der Gruppen 15 als umfangsabschnitthalbierende rechtwinkelig schneiden, und an den Schnittpunkten mit den umfangsabschnittbildenden Kontaktstreifen 8 verbunden sind. Die jeweils drei in den Fig. 2 und Fig. 3 dargestellten Ausführungsbeispielen sind dabei aufgrund der dargestellten Anordnung der Gruppen 15 jeweils geradlinig von einer Seite 10 der Solarzelle 1 zu einer gegenüberliegenden Seite 11 der Solarzelle 1 verlaufend angeordnet.

Die Ableitstrukturen 7 können gemäß dem Stand der Technik auf mehrere Arten auf die Oberfläche 6 der ersten Schicht 2 aufgebracht bzw. mit der ersten Schicht 2 kontaktiert werden. Als Beispiele seien Siebdruck oder Gasabscheideprozesse genannt. Als Basismaterial für mittels Siebdruck aufgebrachte Ableitstrukturen werden häufig Silberpasten verwendet, wobei das Silber als metallischer Leiter dient. Üblicherweise werden bei derartigen Prozessen zum Beispiel Masken verwendet, um die gewünschte, geometrische Ausgestaltungsform der Ableitstruktur 7 zu erzielen. Wenn auf der ersten Schicht 2 weitere Schichten, wie zum Beispiel Antireflexionsschichten aufgebracht sind, kann beispielsweise im Zuge eines Siebdruckprozesses auch der Einsatz von Ätzchemikalien notwendig sein. Da die Methode zur Aufbringung der Ableitstruktur 7 nicht Bestandteil der vorliegenden Erfindung ist, wird diesbezüglich lediglich auf die einschlägige Literatur zum Stand der Technik hingewiesen. Es wird lediglich angemerkt, dass alle zur Aufbringung bzw. Kontaktierung von metallischen Ableitstrukturen auf bzw. mit Halbleiterschichten, geeigneten Methoden selbstverständlich auch zur Herstellung einer erfindungsgemäßen Solarzelle mit der entsprechenden Ableitstruktur in Frage kommen.

Um die Anordnung der Gruppen 15 von regulären Hexagonen 13 in der Ableitstruktur 7 möglichst optimal an die jeweilige äußere Umfangsgeometrie bzw. Kontur der Solarzelle 1 anpassen zu können ,sind die Gruppen 15 von regulären Hexagonen 13 bevorzugt zumindest an Teilbereichen der Oberfläche 6, insbesondere an einem Zentralbereich der Oberfläche 6, ausgebildet, wie dies auch in den Ausführungsbeispielen gemäß Fig. 2 und Fig. 3 dargestellt ist.

Weiters kann es zweckmäßig sein, wenn die Anzahl der konzentrisch um einen gemeinsamen Mittelpunkt 17 angeordneten, regulären Hexagone 13 aus einem Bereich zwischen 4 und 8, und bevorzugt zwischen 5 und 7 ausgewählt ist. Wie es auch in den Ausführungsbeispielen gemäß Fig. 2 und Fig. 3 dargestellt ist, kann es insbesondere zweckmäßig sein, wenn in einer Gruppe 15 von regulären Hexagonen 13 jeweils 6 reguläre Hexagone 13 konzentrisch um einen gemeinsamen Mittelpunkt 17 angeordnet sind. Dadurch sind hinsichtlich Wirkungsgrad und Leistungsausbeute der Solarzelle 1, besonders günstige Anordnungen der der Gruppen 15 von regulären Hexagonen 13 in der Ableitstruktur 7 bzw. der Sammelschienen 9 an der Oberfläche 6 der ersten Schicht 2 erzielbar.

Im Zuge von vergleichenden Untersuchungen zur Ausgestaltung der Ableitstrukturen 7 von Solarzellen 1 hat sich herausgestellt, dass es vorteilhaft sein kann, möglichst viele der Gruppen 15 von regulären Hexagonen 13 in möglichst dichter Packung an der Oberfläche 6 der ersten Schicht 2 anzuordnen. Daher kann es sinnvoll sein, dass wenigstens einer der sechs Umfangsabschnitte 14 des regulären Hexagons 13 mit dem größten Inkreisradius 16 einer Gruppe 15 von konzentrisch angeordneten, regulären Hexagonen 13, beabstandet, direkt benachbart und parallel ausgerichtet zu einem Umfangsabschnitt 14 des regulären Hexagons 13 mit dem größten Inkreisradius 16 einer benachbarten Gruppe 15 angeordnet ist (nicht dargestellt). Wenn die jeweiligen Inkreisradien 16 der regulären Hexagone 13 mit dem jeweilig größten Inkreisradius 16 der direkt benachbarten Gruppen 15 gleich sind, können die Gruppen 15 von regulären Hexagonen 13 insbesondere in einer möglichst dichten Packung in der Ebene der Oberfläche 6 der ersten Schicht 2 angeordnet sein.

Wie es in den Ausführungsbeispielen gemäß Fig. 2 und Fig. 3 dargestellt ist, kann auch vorgesehen sein, dass wenigstens einer der sechs Umfangsabschnitte 14 des regulären Hexagons 13 mit dem größten Inkreisradius 16 einer Gruppe 15 von regulären Hexagonen 13, den Umfangsabschnitt 14 eines regulären Hexagons 13 mit dem größten Inkreisradius 16 einer benachbarten Gruppe 15 bildet. Auch auf diese Weise können die Gruppen 15 von regulären Hexagonen 13 möglichst dicht gepackt an der Oberfläche 6 der ersten Schicht 2 angeordnet sein. Zusätzlich ergibt sich der Vorteil, dass dadurch zusätzliche Ableitpfade für einen jeweiligen, abzuleitenden Ladungsträger bereitgestellt sind, über welche der jeweilige Ladungsträger zu wenigstens zwei der Sammelschienen 9 abgeleitet werden kann. Insbesondere sind durch eine derartige Ausgestaltung der Ableitstruktur 7 der Solarzelle 1, betreffend die ein jeweils reguläres Hexagon 13 mit dem größten Inkreisradius 16 einer Gruppe 15, weitere Kontaktstellen 12 zu wenigstens 2 Sammelschienen 9 geschaffen, wie dies durch Betrachtung der in der Fig. 2 und der Fig. 3 dargestellten Ausführungsbeispiele klar ersichtlich ist.

Aufgrund bzw. in Abhängigkeit von der äußeren Kontur bzw. Umfangsgeometrie der Solarzelle 1 können gegebenenfalls nicht alle Bereiche durch die vorteilhafte Gruppen 15 von regulären Hexagonen 13 abgedeckt bzw. kontaktiert werden. Daher kann weiters vorgesehen sein, dass die Ableitstruktur 7 in Teilbereichen der Oberfläche 6, insbesondere in Randbereichen der Oberfläche 6, durch weitere geradlinig ausgebildete Kontaktstreifen 8 gebildet ist. Insbesondere kann vorgesehen sein, dass diese weiteren Kontaktstreifen 8 entweder senkrecht zu den Sammelschienen 9 verlaufend, oder in einem Winkel von 30° bezüglich der Sammelschienen 9 verlaufend, ausgerichtet sind. Wie aus den in Fig. 2 und Fig. 3 dargestellten Ausführungsbeispielen für die Solarzelle 1 ferner ersichtlich ist, können Teilmengen dieser weiteren Kontaktstreifen 8, welche kein Bestandteil eines regulären Hexagons 13 einer Gruppe 15 sind bzw. kein reguläres Hexagon 13 bilden, dabei aufeinander zulaufend, und an ihren jeweiligen Berührungspunkten zwischen sich einen Winkel von 120° einnehmend, angeordnet sein. Dadurch ist eine sehr gute Anpassung der Anordnung der weiteren Kontaktstreifen 8 an benachbarte Gruppen 15 von regulären Hexagonen 13 ermöglicht. Insbesondere kann so eine hochsymmetrische, die Oberfläche 6 optimal kontaktierende Ableitstruktur 7 bereitgestellt werden.

In dem Ausführungsbeispiel gemäß der Fig. 2 sind außerdem weitere, geradlinig ausgebildete und senkrecht auf die Kontaktschienen 9 verlaufende Kontaktstreifen 8 dargestellt bzw. angeordnet, welche zwei jeweils nächstliegende Ecken von zwei konzentrisch benachbart in der Gruppe 15 angeordneten Hexagonen 13 verbinden. Derartig angeordnete, weitere Kontaktstreifen 8 können je nach der Ausgestaltung der Ableitstruktur 7 in einer oder mehreren der Gruppen 15 von regulären Hexagonen 13 angeordnet sein, wobei durch solche Kontaktstreifen 8 für Ladungsträger quasi Abkürzungen zum Erreichen einer Sammelschiene 9 bereitgestellt sind.

Ferner kann vorgesehen sein, in jeder Gruppe 15 von konzentrisch um einen gemeinsamen Mittelpunkt 17 angeordneten, regulären Hexagonen 13, jeweils zwei T-förmig ausgebildete Kontaktstreifen 18 angeordnet sind. Wie aus Fig. 2 und Fig. 3 ersichtlich ist, kann dabei einer der T-förmigen Kontaktstreifen 18 ausgehend vom gemeinsamen Mittelpunkt 17 auf einer Seite der Sammelschiene 9, und der andere T-förmige Kontaktstreifen 18 ausgehend vom gemeinsamen Mittelpunkt 17 auf der anderen Seite der Sammelschiene 9 angeordnet sein. Die Dimensionen bzw. Längsausdehnungen bzw. der T-förmigen Kontaktstreifen dabei kleiner als der Inkreisradius 16 des Hexagons 13 mit dem kleinsten Inkreisradius 16 der jeweiligen Gruppe 15 gewählt sein.

Zur Optimierung des Wirkungsgrads der Solarzelle 1 können die Kontaktstreifen 8 der Ableitstruktur 7 eine Breite ausgewählt aus dem Bereich zwischen 70 m und 110 m aufweisen. Unter der Breite eines Kontaktstreifens 8 ist hierbei die Dimension bzw. Ausdehnung des Kontaktstreifens 8 senkrecht auf seine geradlinig verlaufende Längserstreckung zu verstehen. Bevorzugt ist die Breite der Kontaktstreifen 8 ausgewählt aus einem Bereich zwischen 75 m und 100 m. Die Sammelschienen 9 sollen selbstverständlich eine deutlich größere Breite als die Kontaktstreifen 8 der Ableitstruktur 7 aufweisen, da einer jeweiligen Sammelschiene 9 über die Vielzahl mit der Sammelschiene 9 verbundener Kontaktstreifen 8 Ladungsträger zugeführt werden, und somit deutlich höhere elektrische Ströme durch die Sammelschienen 9 fließen, als dies vergleichsweise in einzelnen Kontaktstreifen 8 der Fall ist. Dabei kann die Breite der Sammelschienen 9, vor allem in Abhängigkeit von den Dimensionen der Solarzelle und von der Anzahl an Sammelschienen 9 in weiten Bereichen variiert und optimiert werden.

Außerdem kann vorgesehen sein, dass zwischen jeweils zwei unmittelbar benachbarten und parallel zueinander verlaufenden Kontaktstreifen 8 der Ableitstruktur 7 ein Normalabstand 19 ausgebildet ist, welcher für alle Paare von unmittelbar benachbarten und parallel zueinander ausgerichteten Kontaktstreifen 8 auf der gesamten Oberfläche 6 gleich gewählt ist. Unter dem Normalabstand 19 zwischen zwei unmittelbar benachbarten, parallel zueinander ausgerichteten bzw. verlaufenden Kontaktstreifen 8 wird hierbei der Abstand senkrecht auf die Längserstreckung der jeweiligen beiden Kontaktstreifen 8 verstanden., wie die auch in den Fig. 2 und Fig. 3 dargestellt ist. Der Normalabstand 19 kann dabei sein aus einem Bereich zwischen 2,5 mm und 5 mm ausgewählt sein. Bevorzugt werden die Kontaktstreifen 8 der Ableitstruktur 7 derart an der Oberfläche 6 der ersten Schicht 2 angeordnet, dass der Normalabstand 19 aus einem Bereich zwischen 2,8 und 3,5 mm gewählt ist.

Zur Untersuchung der erzielbaren Leistungsausbeuten bzw. Wirkungsgrade der erfindungsgemäßen Solarzellen, im Vergleich zu den derzeit kommerziell erhältlichen, üblichen Solarzellen wurden Simulationsrechnungen durchgeführt. Zur Durchführung der Simulationen wurde der für diese Zwecke vorgesehene bzw. konzipierte 3D-Simulator Synopsis Sentaurus, Version I_2013.12. verwendet. Mittels dieses 3D-Simulators wurden rechnerisch einerseits Modelle von Referenz-Solarzellen erstellt. Diese Referenzsolarzellen wiesen dabei jeweils eine herkömmliche Ableitstruktur, analog zu der schematisch in Fig. 1 dargestellten Ableitstruktur, mit geradlinig ausgebildeten, ausschließlich senkrecht auf die Sammelschienen ausgerichteten Kontaktstreifen, auf. Zum Vergleich wurden andererseits jeweils Modelle von erfindungsgemäßen Solarzellen, welche beispielsweise Ableitstrukturen gemäß den in Fig. 2 und Fig. 3 dargestellten Ableitstrukturen aufwiesen, erstellt.

Für jede durchgeführte Simulation zum Vergleich zwischen einer Referenzmodellzelle und einer erfindungsgemäß ausgebildeten Modell-Solarzelle wurde lediglich die jeweilige Anordnung der Kontaktstreifen in der Ableitstruktur an der Oberfläche der ersten Schicht der jeweiligen Modellzelle variiert. Alle anderen Parameter der rechnerisch erstellten Modelle für die jeweilige Referenzsolarzelle und die damit zu vergleichende, erfindungsgemäße Solarzelle, wurden für die jeweilige Referenzsolarzelle, und die jeweilige erfindungsgemäß ausgestaltete Solarzelle gleich gewählt. Außerdem wurden für jede durchgeführte Simulationsrechnung zum Vergleichen einer Referenzsolarzelle mit einer erfindungsgemäß ausgestalteten Solarzelle, die Simulationsbedingungen, wie etwa Strahlungsintensität und Umgebungstemperatur etc., gleich gewählt.

In Anlehnung an kommerziell erhältliche Produkte, wurden als Modellsolarzellen dotierte, monokristalline Siliziumzellen erstellt. Der Schichtaufbau der Modelle der jeweils zu vergleichenden Referenzsolarzellen und der erfindungsgemäß ausgestalteten Solarzellen, beinhaltete jeweils ein mit Bor dotiertes Siliziumsubstrat (wenigstens eine zweite Schicht, p-Dotierung), welches an der zum Empfang der Solarstrahlung vorgesehenen Oberfläche eine Phosphor-Gegendotierung (erste Schicht, n-Dotierung) aufwies, wobei die Gesamtschichtdicke des Siliziumsubstrats 180 m betrug. Die jeweiligen, rechnerisch erstellten Modellzellen umfassten außerdem eine Antireflexions-Schicht (SiNₓ, PECVD: plasmaunterstützte Gasphasenabscheidung), sowie eine Aluminium-Rückseitenfeldstruktur an der Rückseite der wenigstens einen zweiten, p-dotierten Schicht. Es wurden sowohl für die Referenzsolarzellen als auch die erfindungsgemäß ausgestalteten Solarzellen Modellzellen mit einer quadratischen Umfangsgeometrie bzw. Kontur erstellt. Für jeden Vergleich zwischen einer Referenzsolarzelle und einer erfindungsgemäß ausgebildeten Solarzelle wurden für die beiden jeweiligen Modellzellen ausschließlich Kontaktstreifen gleicher Breite verwendet. Außerdem wurden für die jeweilige Referenzzelle und die jeweilige erfindungsgemäße Zelle, gleiche Normalabstände zwischen allen unmittelbar benachbarten und parallel zueinander ausgerichteten Kontaktstreifen für die jeweilige Simulation gewählt.

Als Ergebnis jeder durchgeführten Simulation für eine Modellsolarzelle wurde insbesondere - neben weiteren Leistungsparametern, wie Kurzschluss-Stromdichte und Leerlaufspannung - ein Wert für den Wirkungsgrad der jeweils simulierten Modellsolarzelle erhalten. Der 3D-Simulator Synopsis Sentaurus liefert darüber hinaus auch Daten über Verteilung der Stromdichte in der Ableitstruktur und den Sammelschienen, sowie Daten über die Temperaturverteilung.

Durch Vergleich der Ergebnisse der Simulationen für eine jeweilige Referenzzelle und eine jeweilige, erfindungsgemäß ausgestaltete Zelle, wurde gefunden, dass die jeweiligen erfindungsgemäß ausgestalteten Modellzellen höhere Wirkungsgrade als die jeweiligen ReferenzModellzellen aufwiesen. Die erzielbaren Steigerungen des Wirkungsgrads betrugen dabei bis zu 0,215 %. Zusätzlich zeigten die Daten betreffend Stromdichte und Temperatur, dass die erfindungsgemäß ausgestalteten Modellzellen bessere bzw. gleichmäßigere Verteilungen der Stromdichte und der Temperatur in der Ableitstruktur aufweisen, als die jeweils zum Vergleich simulierten Referenzmodellzellen.

Schließlich konnte mittels den Vergleichssimulationen auch gezeigt werden, dass die erfindungsgemäß ausgestalteten Solarzellen eine höhere Resistenz gegenüber Beschädigungen an der Oberfläche der ersten Schicht aufweisen, als die Referenzsolarzellen. Insbesondere sind bei Unterbrechung eines Kontaktstreifens durch Kratzer oder dergleichen, bei den erfindungsgemäßen Solarzellen kleinere bzw. weniger Teilbereiche der Ableitstruktur von den Sammelschienen abgeschnitten, als dies bei den Referenzsolarzellen der Fall ist.

Die Ausführungsbeispiele gemäß Fig. 2 und Fig. 3 zeigen mögliche Ausführungsvarianten der Solarzelle 1, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt.

Weiters können auch Einzelmerkmale oder Merkmalskombinationen aus den gezeigten und beschriebenen unterschiedlichen Ausführungsbeispielen für sich eigenständige, erfinderische oder erfindungsgemäße Lösungen darstellen.

Die den eigenständigen erfinderischen Lösungen zugrundeliegende Aufgabe kann der Beschreibung entnommen werden.

Sämtliche Angaben zu Wertebereichen in gegenständlicher Beschreibung sind so zu verstehen, dass diese beliebige und alle Teilbereiche daraus mitumfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereiche beginnen mit einer unteren Grenze von 1 oder größer und enden bei einer oberen Grenze von 10 oder weniger, z.B. 1 bis 1,7, oder 3,2 bis 8,1, oder 5,5 bis 10.

Vor allem können die einzelnen in den Fig. 2 und Fig. 3 gezeigten Ausführungen den Gegenstand von eigenständigen, erfindungsgemäßen Lösungen bilden. Die diesbezüglichen, erfindungsgemäßen Aufgaben und Lösungen sind den Detailbeschreibungen dieser Figuren zu entnehmen.

Der Ordnung halber sei abschließend darauf hingewiesen, dass zum besseren Verständnis des Aufbaus der Solarzelle diese bzw. deren Bestandteile teilweise unmaßstäblich und/oder vergrößert und/oder verkleinert dargestellt wurden.

### Bezugszeichenaufstellung

- 1: Solarzelle
- 2: Schicht
- 3: Schicht
- 4: Ableitelektrode
- 5: Rückseite
- 6: Oberfläche
- 7: Ableitstruktur
- 8: Kontaktstreifen
- 9: Sammelschiene
- 10: Seite
- 11: Seite
- 12: Kontaktstelle
- 13: Hexagon
- 14: Umfangsabschnitt
- 15: Gruppe
- 16: Inkreisradius
- 17: Mittelpunkt
- 18: Kontaktstreifen
- 19: Normalabstand

## Patentansprüche

1. Solarzelle (1), umfassend eine erste Schicht (2) aus einem ersten Halbleitermaterial, und wenigstens eine zweite Schicht (3) aus einem zweiten Halbleitermaterial, wobei die erste Schicht (2) eine Oberfläche (6) aufweist, welche zum Empfangen von solarer Strahlung vorgesehen ist, auf welcher Oberfläche (6) eine Ladungsträger-Ableitstruktur (7) angeordnet ist, welche Ableitstruktur (7) durch eine Mehrzahl an geradlinig ausgebildeten und mit der ersten Schicht (2) kontaktierten, metallischen Kontaktstreifen (8) gebildet ist, und wobei ferner eine Mehrzahl an Sammelschienen (9) vorhanden ist, wobei jeder Kontaktstreifen (8) jeweils unmittelbar oder mittelbar über einen oder mehrere andere Kontaktstreifen (8) über eine Kontaktstelle (12) mit wenigstens einer der Sammelschienen (9) elektrisch leitungsverbunden ist, wobei mehrere Kontaktstreifen (8) ein reguläres Hexagon (13) mit sechs gleich langen Umfangsabschnitten (14) bilden, wobei ferner mehrere reguläre Hexagone (13) eine Gruppe (15) von regulären Hexagonen (13) ausbilden, und mehrere solcher Gruppen (15) an regulären Hexagonen (13) an der Oberfläche (6) angeordnet sind, wobei die Hexagone (13) jeder Gruppe (15) jeweils unterschiedliche Inkreisradien (16) aufweisen und konzentrisch um einen gemeinsamen Mittelpunkt (17) der jeweiligen Gruppe (15) derart angeordnet sind, dass die Umfangsabschnitte (14) der Hexagone (13) einer jeweiligen Gruppe (15) parallel zueinander ausgerichtet sind, **dadurch gekennzeichnet, dass** die Sammelschienen (9) derart angeordnet sind, dass sie geradlinig und parallel zueinander verlaufend sind und durch den gemeinsamen Mittelpunkt (17) jeder Gruppe (15) eine der Sammelschienen (9) verläuft, sodass jedes Hexagon (13) einer Gruppe (15) an wenigstens zwei Kontaktstellen (12) mit der jeweiligen durch den gemeinsamen Mittelpunkt (17) verlaufenden Sammelschiene (9) elektrisch leitungsverbunden ist.

2. Solarzelle nach Anspruch 1, **dadurch gekennzeichnet, dass** die Gruppen (15) von regulären Hexagonen (13) zumindest an Teilbereichen der Oberfläche (6), insbesondere an einem Zentralbereich der Oberfläche (6), ausgebildet sind.

3. Solarzelle nach Anspruch 1 oder 2, **dadurch gekennzeichnet, dass** die Gruppen (15) von regulären Hexagonen (13) an der Oberfläche (6) derart angeordnet sind, dass die durch den gemeinsamen Mittelpunkt (17) verlaufenden Sammelschienen (9) jeweils zwei gegenüberliegenden Umfangsabschnitte (14) jedes Hexagons (13) der Gruppen (15) als umfangsabschnitthalbierende rechtwinkelig schneiden.

4. Solarzelle nach einem oder mehreren der Ansprüche 1 bis 3, **dadurch gekennzeichnet, dass** die konzentrisch um einen gemeinsamen Mittelpunkt (17) angeordneten, regulären Hexagone (13) aller Gruppen (15) bezüglich ihrer jeweiligen Inkreisradien (16) äquidistant voneinander beabstandet sind, und die jeweiligen Inkreisradien (16) der regulären Hexagone (13) derart gewählt sind, dass alle Gruppen (15) jeweils ein Hexagon (13) mit gleichem Inkreisradius (16) aufweisen, und die Anzahl der konzentrisch um einen gemeinsamen Mittelpunkt (17) angeordneten, regulären Hexagone (13), für alle Gruppen (15) der Solarzelle (1) gleich gewählt ist.

5. Solarzelle nach Anspruch 4, **dadurch gekennzeichnet, dass** die Anzahl der konzentrisch um einen gemeinsamen Mittelpunkt (17) angeordneten, regulären Hexagone (13) aus einem Bereich zwischen 4 und 8, und bevorzugt zwischen 5 und 7 ausgewählt ist.

6. Solarzelle nach Anspruch 5, **dadurch gekennzeichnet, dass** die Anzahl der konzentrisch um einen gemeinsamen Mittelpunkt (17) angeordneten, regulären Hexagone (13) 6 ist.

7. Solarzelle nach einem oder mehreren der vorhergehenden Ansprüche, **dadurch gekennzeichnet, dass** wenigstens einer der sechs Umfangsabschnitte (14) des regulären Hexagons (13) mit dem größten Inkreisradius (16) einer Gruppe (15), beabstandet, direkt benachbart und parallel ausgerichtet zu einem Umfangsabschnitt (14) des regulären Hexagons (13) mit dem größten Inkreisradius (16) einer benachbarten Gruppe (15) angeordnet ist.

8. Solarzelle nach einem oder mehreren der vorhergehenden Ansprüche, **dadurch gekennzeichnet, dass** wenigstens einer der sechs Umfangsabschnitte (14) des regulären Hexagons (13) mit dem größten Inkreisradius (16) einer Gruppe (15), den Umfangsabschnitt (14) eines regulären Hexagons (13) mit dem größten Inkreisradius (16) einer benachbarten Gruppe (15) bildet

9. Solarzelle nach einem oder mehreren der Ansprüche 2 bis 8, **dadurch gekennzeichnet, dass** die Ableitstruktur (7) in Teilbereichen der Oberfläche (6), insbesondere in Randbereichen der Oberfläche (6), weitere geradlinig ausgebildete Kontaktstreifen (8) aufweist, welche entweder senkrecht zu den Sammelschienen (9) verlaufend, oder in einem Winkel von 30° bezüglich der Sammelschienen (9) verlaufend, ausgerichtet sind.

10. Solarzelle nach einem oder mehreren der vorhergehenden Ansprüche, **dadurch gekennzeichnet, dass** in einer oder mehreren der Gruppen (15) von regulären Hexagonen (13) weitere, geradlinig ausgebildete und senkrecht auf die Sammelschienen (9) verlaufende Kontaktstreifen (8) angeordnet sind, welche zwei jeweils nächstliegende Ecken von zwei konzentrisch benachbart in der Gruppe (15) angeordneten Hexagonen (13) verbinden.

11. Solarzelle nach einem oder mehreren der vorhergehenden Ansprüche, **dadurch gekennzeichnet, dass** in jeder Gruppe (15) von konzentrisch um einen gemeinsamen Mittelpunkt (17) angeordneten, regulären Hexagonen (13), jeweils zwei T-förmig ausgebildete Kontaktstreifen (18) angeordnet sind, wobei einer der T-förmigen Kontaktstreifen (18) ausgehend vom gemeinsamen Mittelpunkt (17) auf einer Seite der Sammelschiene (9), und der andere T-förmige Kontaktstreifen (18) ausgehend vom gemeinsamen Mittelpunkt (17) auf der anderen Seite der Sammelschiene (9) angeordnet ist, und die Dimensionen der T-förmigen Kontaktstreifen kleiner sind als der Inkreisradius (16) des Hexagons (13) mit dem kleinsten Inkreisradius (16) der jeweiligen Gruppe (15).

12. Solarzelle nach einem oder mehreren der vorhergehenden Ansprüche, **dadurch gekennzeichnet, dass** eine Breite der geradlinig ausgebildeten Kontaktstreifen (8) ausgewählt ist aus einem Bereich zwischen 70 µm und 120 µm, und bevorzugt zwischen 75 µm und 100 µm.

13. Solarzelle nach einem oder mehreren der vorhergehenden Ansprüche, **dadurch gekennzeichnet, dass** zwischen jeweils zwei unmittelbar benachbarten und parallel zueinander verlaufenden Kontaktstreifen (8) der Ableitstruktur (7) ein Normalabstand (19) ausgebildet ist, welcher für alle Paare von unmittelbar benachbarten und parallel zueinander ausgerichteten Kontaktstreifen (8) auf der gesamten Oberfläche (6) gleich gewählt ist, und welcher Normalabstand (19) ausgewählt ist aus einem Bereich zwischen 2,5 mm und 5 mm, und bevorzugt zwischen 2,8 und 3,5 mm.

## Claims

1. A solar cell (1) comprising a first layer (2) made of a first semiconductor material and at least a second layer (3) made of a second semiconductor material, the first layer (2) having a surface (6) which is provided for receiving solar radiation, on which surface (6) a charge carrier discharge structure (7) is arranged, said discharge structure (7) being composed of a plurality of rectilinearly formed metallic contact strips (8) that have contact with the first layer (2), and further wherein there is a plurality of busbars (9), each contact strip (8) being electrically connected directly or indirectly via one or more other contact strips (8) to at least one of the busbars (9) via a contact point (12), wherein a plurality of contact strips (8) form a regular hexagon (13) with six circumferential sections (14) of equal length, wherein further a plurality of regular hexagons (13) form a group (15) of regular hexagons (13), and a plurality of such groups (15) are disposed on the surface (6) of regular hexagons (13), wherein the hexagons (13) of each group (15) each have different inradii (16) and are concentrically disposed about a common centre (17) of the respective group (15) such that the circumferential portions (14) of the hexagons (13) of a respective group (15) are aligned parallel to each other, **characterised in that** the busbars (9) are arranged such that they are linear and parallel to one another and that one of the busbars (9) extends through the common centre (17) of each group (15) so that each hexagon (13) of a group (15) is electrically connected to at least two contact points (12) to the respective busbar (9) which extends through the common centre (17).

2. Solar cell according to Claim 1, **characterised in that** the groups (15) of regular hexagons (13) are formed at least at partial regions of the surface (6), in particular at a central region of the surface (6).

3. Solar cell according to Claim 1 or 2, **characterised in that** the groups (15) of regular hexagons (13) are arranged on the surface (6) in such a way that the busbars (9) running through the common centre (17) each rectangularly and circumferentially bisect two opposite circumferential sections (14) of each hexagon (13) of the groups (15).

4. Solar cell according to one or more of Claims 1 to 3, **characterised in that** the regular hexagons (13) of all groups (15), which are arranged concentrically around a common centre (17), are equidistantly spaced apart from one another with respect to their respective inradii (16), and the respective inradii (16) of the regular hexagons (13) are selected such that all groups (15) each have a hexagon (13) with the same inradius (16), and the number of regular hexagons (13) arranged concentrically around a common centre (17) is selected the same for all groups (15) of the solar cell (1).

5. Solar cell according to Claim 4, **characterised in that** the number of regular hexagons (13) arranged concentrically around a common centre (17) is selected from a range between 4 and 8, arid preferably between 5 and 7.

6. Solar cell according to Claim 5, **characterised in that** the number of regular hexagons (13) which are arranged concentrically around a common centre (17) is 6.

7. Solar cell according to one or more of the preceding claims, **characterised in that** at least one of the six circumferential portions (14) of the regular hexagon (13) having the largest inradius (16) of a group (15) is spaced at a distance, directly adjacent and parallel to a circumferential portion (14) of the regular hexagon (13) having the largest inradius (16) of an adjacent group (15).

8. Solar cell according to one or more of the preceding claims, **characterised in that** at least one of the six circumferential portions (14) of the regular hexagon (13) having the largest inradius (16) of a group (15) forms the circumferential portion (14) of a regular hexagon (13) having the largest inradius (16) of an adjacent group (15).

9. Solar cell according to one or more of Claims 2 to 8, **characterised in that** the discharge structure (7) has, in partial regions of the surface (6), particularly in edge regions of the surface (6), further rectilinear contact strips (8) which extend either perpendicularly to the busbars (9) or at an angle of 30° with respect to the busbars (9).

10. Solar cell according to one or more of the preceding claims, **characterised in that** in one or more of the groups (15) of regular hexagons (13), further contact strips (8) of linear design are arranged which extend perpendicularly to the busbars (9) and which connect two respectively nearest corners of two hexagons (13) which are arranged concentrically adjacent in the group (15).

11. Solar cell according to one or more of the preceding claims, **characterised in that** in each group (15) of regular hexagons (13) arranged concentrically around a common centre (17), in each case two T-shaped contact strips (18) are arranged, one of the T-shaped contact strips (18) starting from the common centre (17) being arranged on one side of the busbar (9), and the other T-shaped contact strip (18) starting from the common centre (17) being arranged on the other side of the busbar (9), with the dimensions of the T-shaped contact strips being smaller than the inradius (16) of the hexagon (13) with the smallest inradius (16) of the respective group (15).

12. Solar cell according to one or more of the preceding claims, **characterised in that** a width of the rectilinearly formed contact strips (8) is selected from a range between 70 µm and 120 µm, and preferably between 75 µm and 100 µm.

13. Solar cell according to one or more of the preceding claims, **characterised in that** a normal distance (19) is formed between every two directly adjacent and mutually parallel contact strips (8) of the discharge structure (7), which is selected identically for all pairs of directly adjacent and mutually parallel contact strips (8) on the entire surface (6), the selected normal distance (19) being in a range between 2.5 mm and 5 mm, and preferably between 2.8 mm and 3.5 mm.

## Revendications

1. Cellule solaire (1) comprenant une première couche (2) composée d'un premier matériau semi-conducteur, et au moins une deuxième couche (3) composée d'un deuxième matériau semi-conducteur, la première couche (2) présentant une surface (6) prévue pour recevoir le rayonnement solaire, surface (6) sur laquelle il est agencé une structure de déviation de porteurs de charge (7), laquelle structure de déviation (7) est formée par une pluralité de bandes de contact (8) métalliques formant des lignes droites et mises en contact avec la première couche (2), la cellule solaire comprenant en outre une pluralité de barres collectrices (9), chaque bande de contact (8) étant directement ou indirectement reliée électriquement à au moins l'une des barres collectrices (9) par le biais d'une ou de plusieurs autres bandes de contact (8) par un point de contact (12), plusieurs bandes de contact (8) formant un hexagone régulier (13) avec six segments périphériques (14) de même longueur, plusieurs hexagones réguliers (13) constituant un groupe (15) d'hexagones réguliers (13) et plusieurs de ces groupes (15) d'hexagones réguliers (13) étant agencés sur la surface (6), les hexagones (13) de chaque groupe (15) présentant chacun des rayons du cercle inscrit différents (16) et étant agencés de façon concentrique autour d'un point central commun (17) de leur groupe (15), de sorte que les segments périphériques (14) des hexagones (13) d'un même groupe (15) sont orientés parallèles les uns aux autres, **caractérisée en ce que** les barres collectrices (9) sont agencées de telle façon qu'elles forment des lignes droites parallèles les unes aux autres et qu'une des barres collectrices (9) passe par le point central commun (17) de chaque groupe (15), de sorte que chaque hexagone (13) d'un groupe (15) est relié électriquement à au moins deux points de contact (12) avec la barre collectrice (9) qui passe par le point central commun (17).

2. Cellule solaire selon la revendication 1, **caractérisée en ce que** les groupes (15) d'hexagones réguliers (13) sont formés sur des parties des surfaces (6), en particulier sur une zone centrale de la surface (6).

3. Cellule solaire selon la revendication 1 ou 2, **caractérisée en ce que** les groupes (15) d'hexagones réguliers (13) sont agencés sur la surface (6) de telle sorte que les barres collectrices (9) qui passent par le point central commun (17) coupent à la perpendiculaire deux segments périphériques (14) opposés de chaque hexagone (13) des groupes (15) en les coupant en deux.

4. Cellule solaire selon une ou plusieurs des revendications 1 à 3, **caractérisée en ce que** les hexagones réguliers (13) de tous les groupes (15) agencés de façon concentrique autour d'un point central commun (17) sont espacés de façon équidistante en ce qui concerne leurs rayons du cercle inscrit respectifs (16), et **en ce que** les rayons du cercle inscrit respectifs (16) des hexagones réguliers (13) sont choisis de telle sorte que tous les groupes (15) présentent un hexagone (13) avec le même rayon du cercle inscrit (16), et **en ce que** le nombre d'hexagones réguliers (13) disposés de façon concentrique autour d'un point central commun (17) est choisi identique pour tous les groupes (15) de la cellule solaire (1).

5. Cellule solaire selon la revendication 4, **caractérisée en ce que** le nombre d'hexagones réguliers (13) disposés de façon concentrique autour d'un point central commun (17) est choisi dans une plage entre 4 et 8, de préférence entre 5 et 7.

6. Cellule solaire selon la revendication 5, **caractérisée en ce que** le nombre d'hexagones réguliers (13) disposés de façon concentrique autour d'un point central commun (17) est de 6

7. Cellule solaire selon une ou plusieurs des revendications précédentes, **caractérisée en ce qu'**au moins un des six segments périphériques (14) de l'hexagone régulier (13) présentant le plus grand rayon du cercle inscrit (16) d'un groupe (15) est âgencé à distance, directement adjacent et parallèle à un segment périphérique (14) de l'hexagone régulier (13) présentant le plus grand rayon du cercle inscrit (16) d'un groupe adjacent (15).

8. Cellule solaire selon une ou plusieurs des revendications précédentes, **caractérisée en ce qu'**au moins un des six segments périphériques (14) de l'hexagone régulier (13) présentant le plus grand rayon du cercle inscrit (16) d'un groupe (15) forme le segment périphérique (14) d'un hexagone régulier (13) présentant le plus grand rayon du cercle inscrit (16) d'un groupe adjacent (15).

9. Cellule solaire selon une ou plusieurs des revendications 2 à 8, **caractérisée en ce que** la structure de déviation (7) présente dans des parties de la surface (6), en particulier dans les zones périphériques de la surface (6), d'autres bandes de contact (8) réalisées en lignes droites qui s'étendent perpendiculairement aux barres collectrices (9) ou selon un angle de 30° par rapport aux barres collectrices (9).

10. Cellule solaire selon une ou plusieurs des revendications précédentes, **caractérisée en ce que**, dans un ou plusieurs des groupes (15) d'hexagones réguliers (13), il est agencé d'autres bandes de contact (8) formant des lignes droites et s'étendant perpendiculairement aux barres collectrices (9), lesquelles barres de contact relient deux coins contigus de deux hexagones (13) agencés de façon concentrique et adjacente dans le groupe (15).

11. Cellule solaire selon une ou plusieurs des revendications précédentes, **caractérisée en ce que** dans chaque groupe (15) d'hexagones réguliers (13) agencés de façon concentrique autour d'un point central commun (17), il est agencé deux bandes de contact (18) réalisées en forme de T, l'une des bandes de contact (18) en forme de T partant du point central commun (17) sur un côté de la barre collectrice (9), et l'autre bande de contact (18) en forme de T partant du point central commun (17) sur l'autre côté de la barre collectrice (9), et **en ce que** les dimensions des bandes de contact en forme de T sont plus petites que le rayon du cercle inscrit (16) de l'hexagone (13) présentant le plus petit rayon du cercle inscrit (16) du groupe correspondant (15).

12. Cellule solaire selon une ou plusieurs des revendications précédentes, **caractérisée en ce que** la largeur des bandes de contact (8) formant des lignes droites est choisie dans une plage comprise entre 70 µm et 120 µm, et de préférence entre 75 µm et 100 µm.

13. Cellule solaire selon une ou plusieurs des revendications précédentes, **caractérisée en ce qu'**entre deux bandes de contact (8) parallèles et directement adjacentes de la structure de déviation (7), il est formé une distance normale (19) qui est choisie identique sur la totalité de la surface (6) pour toutes les paires de bandes de contact (8) directement adjacentes et parallèles entre elles, cette distance normale (19) étant choisie à partir d'une plage comprise entre 2,5 mm et 5 mm, et de préférence entre 2,8 et 3,5 mm.
